Europäisches Patentamt

European Patent Office

Office européen des brevets

(11) Publication number: **0 090 738**
**B1**

(12) **EUROPEAN PATENT SPECIFICATION**

(45) Date of publication of patent specification: **12.07.89**

(21) Application number: **83400644.7**

(22) Date of filing: **29.03.83**

(51) Int. Cl.⁴: **H 01 L 27/02**

(54) Semiconductor device.

(30) Priority: **30.03.82 JP 50079/82**

(43) Date of publication of application:
**05.10.83 Bulletin 83/40**

(45) Publication of the grant of the patent:
**12.07.89 Bulletin 89/28**

(84) Designated Contracting States:
**DE FR GB**

(56) References cited:
**EP-A-0 029 717**
**GB-A-2 092 379**
**US-A-3 878 551**

**IBM TECHNICAL DISCLOSURE BULLETIN, vol.
21, no. 2, July 1978, pages 656-657, New York,
US; H.HEIMEIER et al.: "Integrated delay
circuit"**

**IBM TECHNICAL DISCLOSURE BULLETIN, vol.
14, no. 8, January 1972, page 2306, New York,
US; E.M.HUBACHER et al.: "Overvoltage
protection in integrated circuits"**

**IBM TECHNICAL DISCLOSURE BULLETIN, vol.
20, no. 10, March 1978, pages 3962-3963, New
York, US; O.ALAMEDDINE: "Protective circuit
for integrated semiconductor devices"**

(73) Proprietor: **FUJITSU LIMITED**
**1015, Kamikodanaka Nakahara-ku
Kawasaki-shi Kanagawa 211 (JP)**

(72) Inventor: **Enomoto, Hiromu**
**Kawaracho-danchi 15-1225 1, Kawara-cho
Saiwai-ku
Kawasaki-shi Kanagawa 210 (JP)**
Inventor: **Yasuda, Yasushi**
**Dai-2 Fukushima-so 2 92, Omaru
Inagi-shi Tokyo 206 (JP)**
Inventor: **Shimauchi, Yoshiki**
**Himawarirezidensu 13 2-888, Nakahara-ku
Kawasaki-shi Kanagawa 211 (JP)**
Inventor: **Tahara, Akinori**
**7-15-25, Kotsubo
Zushi-shi Kanagawa 249 (JP)**

(74) Representative: **Descourtieux, Philippe et al
CABINET BEAU de LOMENIE 55 rue
d'Amsterdam
F-75008 Paris (FR)**

Courier Press, Leamington Spa, England.

(56) References cited:

**PATENTS ABSTRACTS OF JAPAN, vol. 7, no.
233 (E-204)1378r, 15th October 1983; & JP - A -
58 121 663 (NIPPON DENKI K.K.) 20-07-1983**

**PATENTS ABSTRACTS OF JAPAN, vol. 7, no.
170 (E-189)1315r, 27th July 1983; & JP - A - 58
78 452 (TOKYO SHIBAURA DENKI K.K.) 12-05-
1983**

## Description

### Background of the invention
### Field of the invention

The present invention relates to a logic circuit with parallel-connected Schottky diodes connected to outer signal terminals.

### Description of the prior art

It is known that input and/or output circuits are often electrostatically broken. The applicants found that when a Schottky barrier diode formed by bringing an electrode of metal such as aluminium into contact with an epitaxial layer is electrostatically broken, aluminium of the electrode penetrates into the epitaxial layer and reaches the underlying buried layer, resulting in a short circuit. A semiconductor device provided with means for obtaining overvoltage protection in integrated circuits is disclosed in IBM Technical Disclosure Bulletin Vol. 14, January 1972, page 2306, by E. M. Hubacher et al A n$^+$ diffused buried region is provided along the boundary of a p-substrate and n-epitaxial layer so as to form a pn$^+$ junction with a p-isolation diffusion region extending from the surface into the p-substrate through the n-epitaxial layer. The isolation region is connected to a voltage supply (−V) and the n-epitaxial layer to another voltage supply (−V). The pn$^+$ junction serves as a clamp to protect the more sensitive junctions from power supply overvoltage spikes.

### Summary of the invention

An object of the present invention is to provide a logic circuit with parallel-connected Schottky diodes, whose resistance against electrostatical breakage is improved.

This and other objects, features, and advantages of the invention are accomplished by a logic circuit with parallel-connected Schottky diodes connected to outer signal terminals, with each Schottky diode being formed by a structure comprising: a substrate; an epitaxial layer of a first conductivity type formed on said substrate; a buried impurity-doped region of the first conductivity type formed between said substrate and said epitaxial layer; a first electrode formed on said epitaxial layer above said buried impurity-doped region and electrically connected thereto; and a second electrode formed on said epitaxial layer above said buried impurity-doped region to form a Schottky barrier diode with said epitaxial layer, wherein at least one of said Schottky diodes is protected by a structure comprising a second impurity-doped region of a second conductivity type opposite to the first conductivity type, said second impurity-doped region extending from a top surface of the epitaxial layer to said buried impurity-doped region and being in contact with said buried impurity-doped region to form a pn junction therewith, one of the buried impurity-doped region and second impurity-doped region being electrically connected with the outer signal terminal which said protected Schottky diode is connected to and the other one being electrically connected to a power source terminal, whereby electrostatic breakage of said protected Schottky diode due to extraordinary high voltage application from the outer signal terminal is prevented by preferential breakdown of said pn junction.

In the semiconductor device according to the present invention, when a high potential is applied to the buried region, the electrostatic charges stored in the buried region flow through the second impurity-doped region by breakdown of the PN junction therebetween. Thus, the PN junction prevents discharge between the buried layer and an electrode of, e.g. aluminium, which would otherwise result in a short-circuit by penetration of aluminium between them.

The second impurity-doped region may be preferably made by an element isolation region in the semiconductor device.

### Brief description of the drawings

Figure 1 is a wiring diagram of a prior art transistor-transistor logic (TTL) circuit;

Figure 2 is a sectional view of a part of a semiconductor device including the TTL circuit shown in Fig. 1;

Figure 3 is a sectional view of a part of a circuit according to the present invention;

Figure 4 is a wiring diagram of the part shown in Fig. 3;

Figure 5 is a sectional view of a part of another circuit according to the present invention, in which an impurity region is made by an isolation region; and

Figure 6 is a wiring diagram of the part shown in Fig. 5;

### Description of the preferred embodiments

The present invention will now be described in detail in reference to prior art and preferred embodiments.

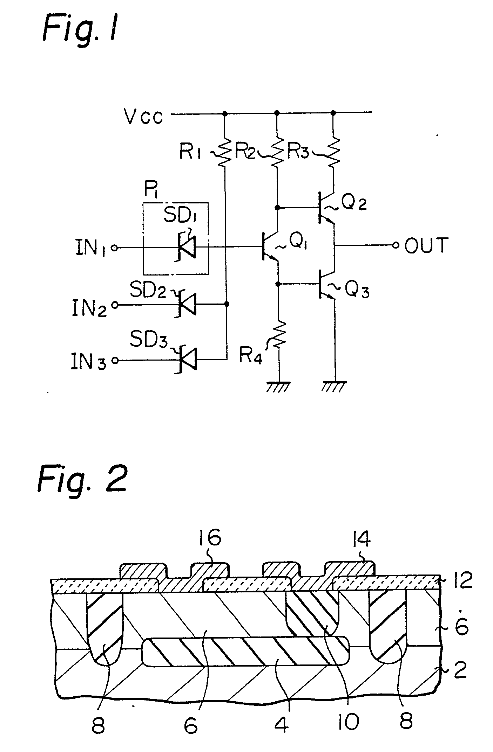

Figure 1 is a wiring diagram of a prior art TTL circuit. Three Schottky diodes $SD_1$, $SD_2$, and $SD_3$ are connected in parallel so as to form a three-input NAND gate at an input stage. In the circuit, $Q_1$ is a phase dividing transistor, $Q_2$ and $Q_3$ are transistors forming a push-pull output stage, $R_1$, $R_2$, $R_3$, and $R_4$ are resistors, and $V_{cc}$ is a power source.

Figure 2 is a sectional view of a part $P_1$ of a semiconductor device included in the prior art TTL circuit shown in Fig. 1, the part $P_1$ being enclosed by a broken line in Fig. 1. In a P-type silicon substrate 2, a buried layer (N$^+$b layer) 4 is formed by diffusion. An N-type epitaxial layer 6 is grown on the substrate 2, and an isolation region 8 and a contact region 10 for the buried layer 4 are formed in the epitaxial layer 6 by P-type and N-type impurity diffusions respectively. In many regions in the epitaxial layer 6, elements including input and/or output elements are formed in accordance with a desired circuit. In Fig. 2, a Schottky barrier diode $SD_1$ is formed by bringing an electrode 16 of metal such as aluminum into contact with the epitaxial layer 6.

Reference numeral 12 denotes an insulating layer, and 14 and 16 electrodes.

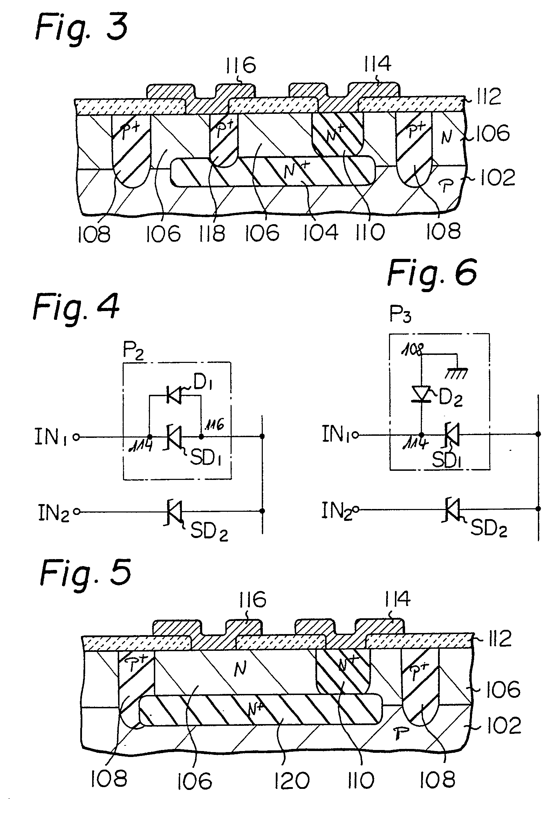

Figure 3 is a sectional view of a part $P_2$ of a semiconductor device according to the present invention. The semiconductor device includes a TTL circuit similar to that shown in Fig. 1 except for the part $P_1$. The part $P_2$ replaces the part $P_1$.

Into a P-type silicon substrate 102, arsenic or antimony is selectively heat diffused at about 1200°C to 1300°C to form a buried layer ($N^+b$ layer) 104. The buried layer 104 is about 3 μm (micrometer) in depth and about 20 Ω/□ in sheet resistance. On the substrate 102, an N-type silicon epitaxial layer 106 is grown. The epitaxial layer 106 is about 4 μm in thickness and about 0.6 to 0.9 Ω · cm in resistance. The surface of the epitaxial layer 106 is oxidised and patterned to open windows for diffusion. These windows include not only windows for element isolation, but also a window at a part of the area where a Schottky diode is later formed. A boron silicate glass layer is formed entirely over the oxide layer. Then, boron existing in the boron silicate glass is heat diffused at about 1200°C through the windows to form isolation regions 108 as well as a boron-diffused region 118 reaching the buried layer 104 under the window at a part of the area where the Schottky diode is to be formed. These boron-diffused regions 108 and 118 are about $10^{20}$ cm$^{-3}$ in boron concentration and about 6 Ω/□ in resistance. Then, according to a conventional process, an $N^+$ contact region 110 is formed, an oxide layer 112 is formed and patterned, and an aluminum layer is deposited and patterned to form electrodes 114 and 116 and conducting lines (not shown).

The thus fabricated part $P_2$ shown in Fig. 3 corresponds to the enclosed part $P_2$ of the wiring diagram shown in Fig. 4. In Fig. 4, the PN junction formed by the contact of the buried layer 104 and the boron-diffused region 118 is expressed by the diode $D_1$.

In a semiconductor device according to the present invention, if an excessively high electrostatic voltage is applied to an input terminal $IN_1$, the charge flows through the diode $D_1$, which has a breakdown voltage lower than the voltage at which electrostatic breakage occurs between the buried layer 104 and the electrode 116, and through a resistor $R_1$ or other parts to a power source or ground. Therefore, the Schottky barrier diode $SD_1$ is not subject to excessive voltage, preventing electrostatic breakage.

To test the resistance against electrostatical breakage of the above fabricated semiconductor device, electrostatic voltage was applied from a charged 200 pF capacitor with no series connected resistance between the input terminal $IN_1$ connected with the electrode 114 and the ground connected with the boron-diffused region 118. The resultant breakage voltage of the Schottky diode $SD_1$ was 230 V. For comparison, a semiconductor device of the prior art, similar to the above semiconductor device except that the boron-diffused region 118 was not formed, was also tested. The resultant voltage was 160 V.

Figure 5 illustrates another semiconductor device according to the present invention, in which an impurity region corresponding to the boron-diffused region 118 in the above example was formed by an element isolation region. In Fig. 5, 102 denotes a silicon substrate, 106 an epitaxial layer, 108 an isolation region, 110 a contact region, 112 an oxide layer, and 114 and 116 electrodes. This semiconductor device was fabricated in the same manner as the above-described semiconductor device, except that an arsenic- or antimony-diffused buried layer 120 was extended so as to have a contact with the boron-diffused isolation region 108 and that no boron-diffused region 118 extending from the electrode 112 to the buried layer 120 in the epitaxial layer 106 was formed. Alternatively, a contact between an arsenic- or antimony-diffused buried layer and a boron-diffused isolation region may be formed by extending the isolation region not the buried layer or by combination thereof. The isolation region 108 having contact with the buried layer 120 is connected with the ground.

The part shown in Fig. 5 corresponds to the enclosed part $P_3$ of the wiring diagram of Fig. 6. The contact of the buried layer 120 and the isolation region 108 is expressed as a diode $D_2$. The thus fabricated semiconductor device having a TTL circuit including the diode $D_2$ was subjected to the same test as mentioned before. The resultant electrostatic breakage voltage was 240 V.

## Claims

1. A logic circuit with parallel-connected Schottky diodes ($SD_1$, $SD_2$, $SD_3$) connected to outer signal terminals ($IN_1$, $IN_2$, $IN_3$), with each Schottky diode being formed by a structure comprising: a substrate (102; 202); an epitaxial layer (106) of a first conductivity type formed on said substrate; a buried impurity-doped region (104; 120) of the first conductivity type formed between said substrate and said epitaxial layer; a first electrode (114) formed on said epitaxial layer above said buried impurity-doped region and electrically connected thereto; and a second electrode (116) formed on said epitaxial layer above said buried impurity-doped region to form a Schottky barrier diode with said epitaxial layer, characterized in that at least one ($SD_1$) of said Schottky diodes is protected by a structure comprising a second impurity-doped region (118; 108) of a second conductivity type opposite to the first conductivity type, said second impurity-doped region extending from a top surface of the epitaxial layer to said buried impurity-doped region (104; 120) and being in contact with said buried impurity-doped region to form a pn junction therewith, one of the buried impurity-doped region (104; 120) and second impurity-doped region (118; 108) being electrically connected with the outer signal terminal ($IN_1$) with said protected Schottky diode ($SD_1$) is connected to and the other one being electrically connected to a power source terminal ($V_{cc}$ or ground), whereby electrostatic breakage of said protected

Schottky diode (SD$_1$) due to extraordinary high voltage application from the outer signal terminal is prevented by preferential breakdown of said pn junction.

2. A semiconductor device according to claim 1, characterized in that a third impurity-doped region (110) of the first conductivity type extends from a top surface of the epitaxial layer (106) to said buried impurity-doped region and is in contact with said electrode (114) and said buried impurity-doped region.

3. A semiconductor device according to any one of claims 1 to 3, characterized in that said buried impurity-doped region (104; 120) is electrically connected with said outer signal terminal (INI).

4. A semiconductor device according to any one of claims 1 to 3, characterized in that said second impurity-doped region (118) is in contact with said second electrode (116).

5. A semiconductor device according to any one of claims 1 to 4, characterized in that it includes an element-isolating impurity-doped region (108) of a second conductivity type, extending from a top surface of the epitaxial layer (106) into the substrate (102) and defining a region of the epitaxial layer enclosed by said element-isolating impurity-doped region as an element-forming region.

6. A semiconductor device according to claim 5 characterized in that said element-isolating impurity-doped region (108) constitutes said second impurity-doped region forming a pn junction with said buried impurity-doped region (120).

## Patentansprüche

1. Logikschaltung mit parallel verbundenen Schottky-Dioden (SD$_1$, SD$_2$, SD$_3$), die mit äußeren Signalanschlüssen (IN$_1$, IN$_2$, IN$_3$) verbunden sind, wobei jede Schottky-Diode durch eine Struktur gebildet ist, die umfaßt: ein Substrat (102; 202); eine epitaktische Schicht (106) von einem ersten Leitfähigkeitstyp, die auf dem genannten Substrat gebildet ist; einen vergrabenen, mit Verunreinigungen dotierten Bereich (104, 120) von dem ersten Leitfähigkeitstyp, der zwischen dem genannten Substrat und der genannten epitaktischen Schicht gebildet ist; eine erste Elektrode (114), die auf der genannten epitaktischen Schicht oberhalb des genannten vergrabenen mit Verunreinigungen dotierten Bereiches gebildet und mit diesem elektrisch verbunden ist; und eine zweite Elektrode (116), die auf der genannten epitaktischen Schicht oberhalb des genannten vergrabenen, mit Verunreinigungen dotierten Bereichs gebildet ist, um eine Schottky-Grenzschichtdiode mit der genannten epitaktischen Schicht zu bilden, dadurch gekennzeichnet, daß wenigstens eine (SD$_1$) der genannten Schottky-Dioden durch ein Struktur geschützt ist, welche einen zweiten mit Verunreinigungen dotierten Bereich (118, 108) von einem zweiten Leitfähigkeitstyp, entgegengesetzt zu dem ersten Leitfähigkeitstyp, umfaßt, welcher genannte zweite mit Verunreinigungen dotierte Bereich sich von einer oberen Oberfläche der epitaktischen Schicht zu dem genannten vergrabenen, mit Verunreinigungen dotierten Bereich (104; 120) erstreckt und mit dem genannten vergrabenen, mit Verunreinigungen dotierten Bereich in Kontakt ist, um mit diesem einen pn-Übergang zu bilden, wobei ein vergrabener, mit Verunreinigungen dotierter Bereich (104; 120) und der zweite mit Verunreinigungen dotierte Bereich (118, 108) mit dem äußeren Signalanschluß (IN$_1$) elektrisch verbunden sind, mit dem die genannte geschützte Schottky-Diode (SD$_1$) verbunden ist, und der andere elektrisch mit einem Energiequellenanschluß (V$_{CC}$ oder Erde) verbunden ist, wodurch ein elektrostatischer Durchbruch der genannten geschützten Schottky-Diode (SD$_1$) aufgrund einer außerordentlich hohen Spannungsbeaufschlagung von dem äußeren Signalanschluß durch vorzugsweisen Durchbruch des genannten pn-Übergangs verhindert wird.

2. Halbleitervorrichtung nach Anspruch 1, dadurch gekennzeichnet, daß ein dritter mit Verunreinigungen dotierter Bereich (110) von dem ersten Leitfähigkeitstyp sich von einer oberen Oberfläche der epitaktischen Schicht (106) zu dem genannten vergrabenen, mit Verunreinigungen dotierten Bereich erstreckt und mit der genannten Elektrode (114) und dem genannten vergrabenen, mit Verunreinigungen dotierten Bereich in Kontakt ist.

3. Vorrichtung nach einem der Ansprüche 1 bis 3, dadurch gekennzeichnet, daß der genannte, mit Verunreinigungen dotierte Bereich (104; 120) mit dem genannten äußeren Signalanschluß (INI) elektrisch verbunden ist.

4. Halbleitervorrichtung nach einem der Ansprüche 1 bis 3, dadurch gekennzeichnet, daß der genannte zweite mit Verunreinigungen dotierte Bereich (118) mit der genannten zweiten Elektrode (116) in Kontakt ist.

5. Halbleitervorrichtung nach einem der Ansprüche 1 bis 4, dadurch gekennzeichnet, daß sie einen ein Element isolierenden, mit Verunreinigungen dotierten Bereich (108) von einem zweiten Leitfähigkeitstyp umfaßt, der sich von einer oberen Oberfläche der epitaktischen Schicht (106) in das Substrat (102) erstreckt und einen Bereich der epitaktischen Schicht begrenzt, der durch den genannten elementisolierenden, mit Verunreinigungen dotierten Bereich als einem elementbildenden Bereich eingeschlossen ist.

6. Halbleitervorrichtung nach Anspruch 5, dadurch gekennzeichnet, daß der genannte elementisolierende, mit Verunreinigungen dotierte Bereich (108) den genannten zweiten mit Verunreinigungen dotierten Bereich bildet, welcher einen pn-Übergang mit dem genannten vergrabenen, mit Verunreinigungen dotierten Bereich (120) bildet.

## Revendications

1. Circuit logique doté de diodes de Schottky connectées en parallèle (SD$_1$, SD$_2$, SD$_3$) qui sont connectées à des bornes de signaux extérieurs (IN$_1$, IN$_2$, IN$_3$), chaque diode de Schottky étant formée par une structure comprenant: un substrat (102; 202); une couche épitaxiale (106) d'un premiere type de conductivité formée sur ledit substrat; une région enterrée dopée par des impuretés (104; 120) possédant le premier type de conductivité et formée entre ledit substrat et ladite couche épitaxiale; une première électrode (114) formée sur ladite couche épitaxiale au-dessus de ladite région enterrée dopée par des impuretés et électriquement connectée à celle-ci; et une deuxième électrode (116) formée sur ladite couche épitaxiale au-dessus de ladite région enterrée dopée par des impuretés afin de former une diode à barrière de Schottky avec ladite couche épitaxiale, caractérisé en ce qu'au moins une (SD₁) desdites diodes de Schottky est protégée par une structure comprenant une deuxième région dopée par des impuretés (118; 108) possédant un deuxième type de conductivité opposé au premier type de conductivité, ladite deuxième région dopée par des impuretés s'étendant de la surface supérieure de la couche épitaxiale jusqu'à ladite région enterrée dopée par des impuretés (104; 120) et étant en contact avec ladite région enterrée dopée par des impuretés afin de former une jonction pn avec celle-ci, l'une des régions que constituent la région enterrée dopée par des impuretés (104; 120) et la deuxième région dopée par des impuretés (118; 108) étant électriquement connectée avec la borne de signaux extérieurs (IN₁) à laquelle ladite diode de Schottky (SD₁) protégée est connectée et l'autre étant électriquement connectée à une borne d'une source d'alimentation (V_CC ou la terre), si bien que la rupture électrostatique de ladite diode de Schottky (SD₁) protégée qui serait provoquée par l'application d'une tension exceptionnellement élevée en provenance de la borne de signaux extérieurs est empêchée par le claquage préférentiel de ladite jonction pn.

2. Dispositif à semiconducteurs selon la revendication 1, caractérisé en ce qu'une troisième région dopée par des impuretés (110) qui possède le premier type de conductivité s'étend de la surface supérieure de la couche épitaxiale (106) jusqu'à ladite région enterrée dopée par des impuretés et est en contact avec ladite électrode (114) et ladite région enterrée dopée par des impuretés.

3. Dispositif à semiconducteurs selon l'une quelconque des revendications 1 à 3, caractérisé en ce que ladite région enterrée dopée par des impuretés (104; 120) est électriquement connectée à ladite borne de signaux extérieurs (INI).

4. Dispositif à semiconducteurs selon l'une quelconque des revendications 1 à 3, caractérisé en ce que ladite deuxième région dopée par des impuretés (118) est en contact avec ladite deuxième électrode (116).

5. Dispositif à semiconducteurs selon l'une quelconque des revendications 1 à 4, caractérisé en ce qu'il comporte une région dopée par des impuretés d'isolation d'élément (108) possédant un deuxième type de conductivité, qui s'étend de la surface supérieure de la couche épitaxiale (106) jusque dans le substrat (102) et qui définit une région de la couche épitaxiale entourée par ladite région dopée par des impuretés d'isolation d'élément faisant fonction de région de formation d'élément.

6. Dispositif à semiconducteurs selon la revendication 5, caractérisé en ce que ladite région dopée par des impuretés d'isolation d'élément (108) constitue ladite deuxième région dopée par des impuretés formant une jonction pn avec ladite région enterrée dopée par des impuretés (120).

*Fig. 1*

*Fig. 2*

## Fig. 3

## Fig. 4

## Fig. 6

## Fig. 5